Europäisches Patentamt

**European Patent Office**

Office européen des brevets

(19)

(11) Numéro de publication: **0 057 480**
A1

(12) ## DEMANDE DE BREVET EUROPEEN

(21) Numéro de dépôt: **82200069.1**

(22) Date de dépôt: **21.01.82**

(51) Int. Cl.³: **H 03 D 9/06,** H 03 B 5/18

(30) Priorité: **28.01.81 FR 8101618**

(43) Date de publication de la demande: **11.08.82**
**Bulletin 82/32**

(84) Etats contractants désignés: **DE FR GB IT SE**

(71) Demandeur: **Laboratoires d'Electronique et de Physique Appliquee L.E.P., 3, Avenue Descartes, F-94450 Limeil-Brevannes (FR)**

(84) Etats contractants désignés: **FR**

(71) Demandeur: **N.V. Philips' Gloeilampenfabrieken, Pieter Zeemanstraat 6, NL-5621 CT Eindhoven (NL)**

(84) Etats contractants désignés: **DE GB IT SE**

(72) Inventeur: **Tsironis, Christos, Société Civile S.P.I.D. 209 rue de l'Université, F-75007 Paris (FR)**

(74) Mandataire: **Gendraud, Pierre et al, Société Civile S.P.I.D. 209, rue de l'Université, F-75007 Paris (FR)**

(54) **Dispositif oscillateur-mélangeur stabilisé par un résonateur diélectrique.**

(57) L'invention concerne un dispositif oscillateur-mélangeur, du type comportant un transistor à effet de champ à double grille du type Schottky, destiné à fournir un signal de sortie à une fréquence dite intermédiaire, obtenu par mélange soustractif d'un signal d'entrée à haute fréquence et d'un signal créé dans le dispositif, le signal d'entrée étant appliqué sur la première électrode de grille ($G_1$), le signal créé étant contrôlé par la deuxième électrode de grille ($G_2$), et le signal de sortie étant récupéré sur l'électrode de drain (D), alors que l'électrode de source (S) est directement reliée à la masse, remarquable en ce qu'un ligne du type microruban, d'une impédance caractéristique $Z_0$, couplée magnétiquement avec un résonateur diélectrique et chargée par une impédance ($Z_0$) est connectée à ladite deuxième électrode de grille ($G_2$).

L'invention a trait au domaine des circuits hyperfréquences, et est destinée à être insérée dans une tête intégrée de réception d'ondes hyperfréquences, typiquement de fréquence 12 GHz, utilisée dans la distribution de programmes de radio-télévision par satellites artificiels.

Application: réception des programmes de radio-télévision par satellites artificiels.

DISPOSITIF OSCILLATEUR-MELANGEUR STABILISE PAR UN RESONATEUR
DIELECTRIQUE

L'invention concerne un dispositif oscillateur-mélangeur
du type comportant un transistor à effet de champ à double grille du
type Schottky, destiné à fournir un signal de sortie à une fréquence
dite intermédiaire, obtenu par mélange soustractif d'un signal d'entrée
à haute fréquence et d'un signal créé dans le dispositif, le signal
d'entrée étant appliqué sur la première électrode de grille ($G_1$),
le signal créé étant contrôlé par la deuxième électrode de grille ($G_2$),
et le signal de sortie étant récupéré sur l'électrode de drain (D),
alors que l'électrode de. source (S) est directement reliée à la masse.
L'invention a trait au domaine des circuits hyperfréquences, plus
spécifiquement à la réception des ondes hyperfréquences.

Un tel circuit est destiné à être inséré dans une tête
intégrée de réception d'ondes hyperfréquences, typiquement de fréquence 12 GHz, utilisées dans la distribution de programmes de radio-
télévision par satellites artificiels. Ces programmes peuvent être captés au sol par des stations de réception de dimensions relativement
importantes, puis diffusés par des réseaux locaux, ou bien, par des
petites stations communautaires desservant des écoles, des centres
d'informations, ou des immeubles , et même individuelles, notamment
dans les régions non couvertes par les réseaux d'émetteurs au sol.

D'une manière très générale, une tête de réception constitue l'interface entre l'antenne de réception et les circuits de
réception du poste de télévision. Sa fonction consiste à amplifier le
signal provenant de l'antenne et à abaisser sa fréquence de 12 GHz à
1 GHz. Par tête "intégrée" on entend qu'elle est constituée à partir
de circuits intégrés, typiquement par des transistors à effet de champ,
en arséniure de gallium, en raison de leurs bonnes performances en
hyperfréquences.

L'abaissement de fréquence, de 12 GHz, fréquence attribuée
par le CCIR pour les télécommunications par satellites artificiels, à
1 GHz, fréquence intermédiaire avant démodulation par les circuits du
récepteur de télévision, est connu de l'art antérieur. Il nécessite généralement la présence d'un oscillateur local, à la fréquence d'environ 11 GHz, et d'un mélangeur d'où l'on extrait en sortie un signal de 1 GHz. On citera, pour exemple, les schémas respectifs d'un oscillateur local et d'un mélangeur, publiés dans Inter Electronique du 28 Avril 1978.

L'intégration de plus en plus poussée de la tête de réception, nécessitée par la diminution des coûts de fabrication d'un tel système, a conduit la Demanderesse à rechercher un composant qui associe à la fois les fonctions de mélangeur et d'oscillateur.

Le transistor à effet de champ, à double grille du type Schottky convient à cet effet. Il est connu de l'art antérieur son utilisation en tant que mélangeur, et l'on citera pour exemple la publication ayant pour titre : "An X- Band Dual Gate Fet Mixer", par S.C. Cripps et d'autres, Proc. 1977  European Microwave Conference. Son utilisation en tant qu'oscillateur-mélangeur est également connue, et l'on citera pour exemple, la publication ayant pour titre : "A self oscillating dual gate Mesfet X-Band Mixer, with 12 dB conversion gain", par C.Tsironis et d'autres, dans 9th European Microwave Conference Dig. Techn. Papers, Brighton, England, en Septembre 1979.

Selon cette dernière publication, la deuxième électrode de grille d'un transistor MESFET double-grille est connectée à une ligne, du type microruban et de longueur variable, dont l'extrémité est en court-circuit.

Ce dispositif constitue effectivement un oscillateur-mélangeur ; toutefois, il présente notamment l'inconvénient de ne pas pouvoir être stabilisé au moyen d'un résonateur, et de ce fait, sa fréquence d'oscillation est relativement instable, ce qui interdit son utilisation dans la tête de réception d'ondes hyperfréquences pour télévision.

L'invention vise à pallier le susdit inconvénient en proposant un autre montage propre à être stabilisé.

Le dispositif oscillateur-mélangeur, selon la présente invention, est remarquable en ce qu'une ligne du type microruban, d'une impédance caractéristique $Z_0$, couplée magnétiquement avec un résonateur diélectrique et chargée par une impédance ($Z_0$), est connectée à ladite deuxième électrode de grille ($G_2$).

De cette manière, le transistor engendre un signal dont la fréquence est celle de résonance du résonateur diélectrique.

Dans une utilisation particulière du dispositif selon la présente invention, celui-ci fonctionne comme un oscillateur simple.

Selon une réalisation préférentielle du dispositif oscillateur-mélangeur, les entrée et sortie sont adaptées aux fréquences de fonctionnement utilisées de manière à augmenter le gain de conversion.

Selon une réalisation préférentielle du dispositif oscillateur, les entrée et sortie sont adaptées à la fréquence d'oscillation choisie, de manière à augmenter la puissance d'oscillation.

La description qui va suivre, en regard des dessins annexés, permettra de mieux comprendre comment l'invention se réalise et de mieux en apprécier sa portée.

La figure 1 est un schéma de l'oscillateur-mélangeur selon la présente invention.

La figure 2 est le tracé du cercle d'instabilité du transistor MESFET double-grille à une fréquence choisie par exemple de 11 GHz, et de l'impédance vue par la deuxième grille $(G_2)$ en fonction de la fréquence, dans le diagramme de Smith.

La figure 3, une courbe représentant le gain de conversion en fonction de la fréquence du signal d'entrée reçu.

La figure 4 est un schéma d'un oscillateur, selon la présente invention.

La figure 5 est le tracé des cercles d'instabilité du transistor MESFET double grille, et de l'impédance vue par la deuxième grille $(G_2)$ en fonction de la fréquence, dans le diagramme de Smith ;

et la figure 6, une courbe représentant la puissance délivrée par l'oscillateur et le facteur de qualité $Q_{ext}$ en fonction de la polarisation de l'électrode de drain.

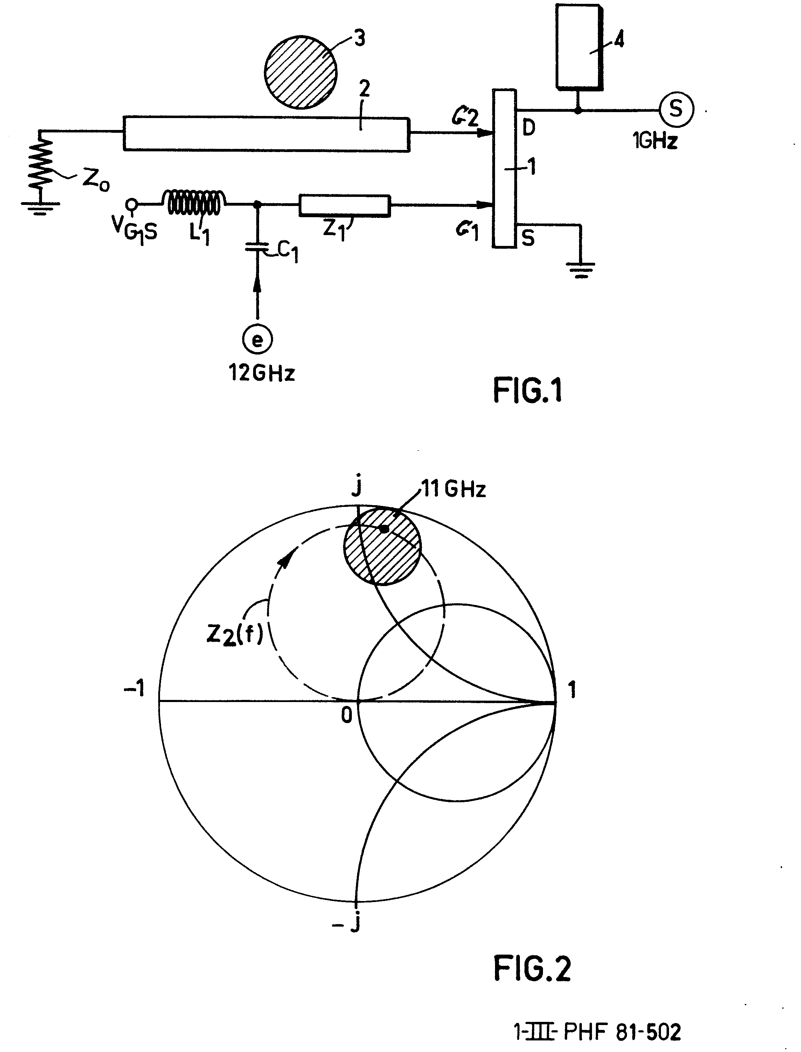

Un dispositif oscillateur-mélangeur conforme à la présente invention comprend un transistor à effet de champ, à double grille du type Schottky (en anglais, "dual-gate MESFET"), référencé 1 à la figure 1, qui est l'élément actif à la fois de l'oscillateur et du mélangeur.

Un tel transistor est bien connu de l'art antérieur, et l'on citera pour mémoire la publication de l'article "Dual-Gate GaAs microwave FET", par J. Turner et d'autres, dans Electronic Letters,

4                                              0057480

Vol. 7, p.661-662, en Novembre 1971. Ses applications extrêmement variées sont toutefois plus récentes, et ont été divulguées de 1975 à ce jour, ainsi, celle d'oscillateur-mélangeur date de 1979.

Dans cette dernière application, le signal d'entrée est appliqué préférentiellement sur la première électrode de grille ($G_1$), comptée à partir de l'électrode de source (S), et le signal créé est contrôlé par la deuxième électrode de grille ($G_2$), alors que le signal de sortie est récupéré sur l'électrode de drain (D).

En effet, cette disposition semble être la plus favorable, ainsi qu'il ressort des enseignements tirés de la publication dans IEEE (1978), p.309-311, de l'article intitulé : "Dual-gate GaAs Fet as a frequency multiplier at Ku-Band", notamment des courbes de trans-conductance en fonction des tensions de polarisation de la première électrode de grille, par rapport à la source ($V_{G_1S}$), pour différentes tensions de polarisation de la seconde électrode de grille, par rapport à la source ($V_{G_2S}$). La disposition inverse peut également être envisagée avec un moindre profit, sans sortir pour cela du cadre de la présente invention.

Le dispositif mélangeur auto-oscillant 1, selon la figure 1, comporte donc une électrode de source (S) directement reliée à la masse, une première électrode de grille ($G_1$) sur laquelle est appliqué le signal d'entrée à haute fréquence (12 GHz) provenant par exemple du satellite artificiel, à travers un condensateur $C_1$ et une impédance $Z_1$, alors qu'une tension de polarisation $V_{G_1}$ est appliquée à travers une inductance $L_1$ et l'impédance $Z_1$, une deuxième électrode de grille ($G_2$) qui, conformément à la présente invention, est connectée à une première extrémité d'une ligne 2 de type microruban, d'impédance caractéristique $Z_0$, typiquement de 50 Ω, l'autre extrémité étant chargée par une impédance $Z_0$, de même valeur, alors que ladite ligne 2 est couplée magnétiquement avec un résonateur diélectrique, et enfin une électrode de drain (D) sur laquelle est recueilli le signal de sortie, à une fréquence intermédiaire (par exemple à 1 GHz), alors qu'une ligne ouverte quart d'onde 4 qui se comporte comme un court-circuit pour les fréquences du signal d'entrée et du signal créé est branchée en parallèle.

De cette manière, le dispositif se comporte à la fois comme un oscillateur, en ce qu'il crée un signal dont la fréquence (par exemple 11 GHz) est stabilisée par un résonateur diélectrique, et comme un mélangeur en ce qu'il mélange les signaux d'entrée et crée un filtrage adéquat permettant de récupérer en sortie un signal obtenu par mélange soustractif, c'est-à-dire dont la fréquence est la différence de celles des deux signaux appliqués sur ou contrôlés par les deux électrodes de grille ($G_1$ et $G_2$).

A cet égard, il peut être utile de rappeler ici que la stabilisation de la fréquence d'un signal au moyen d'un résonateur diélectrique tel qu'un disque de céramique de $Ba_2.Ti_9.O_{20}$, ou plus généralement du système $BaO-TiO_2$ est bien connue de l'art antérieur, notamment de la publication par J.K. Plourde et d'autres, dans Journal of American Ceramic Soc. , Vol. 58, p.418-420, Novembre 1978 de l'article "$Ba_2.Ti_9.O_{20}$ as a microwave dielectric resonator", l'invention consistant à réaliser un nouveau circuit oscillant comportant un transistor à effet de champ à double grille du type Schottky, apte à être stabilisé par ce moyen.

La présence de ce résonateur diélectrique, par exemple sous la forme d'un disque de titanate de baryum, logé dans une boîte métallique fermée ou monté directement sur le même substrat en alumine que le transistor, permet d'obtenir un facteur de qualité externe aussi élevé que 2000, et également de supprimer toute oscillation parasite indésirable. En outre, le positionnement de ce disque par rapport à la ligne microruban est facilement reproductible.

En effet, le couplage magnétique entre le résonateur diélectrique et la ligne microruban chargée, connectée à la deuxième grille ($G_2$) du transistor double grille entraîne les conséquences suivantes :

       - le transistor oscille sur la fréquence de résonance du résonateur diélectrique, extrêmement stable en température ;

       - le transistor n'oscille pas sur d'autres fréquences ;

       - le transistor n'oscillerait pas en l'absence du résonateur. Ces conséquences proviennent du fait que l'impédance vue par l'entrée, sur cette deuxième électrode de grille ($G_2$) traverse une zone d'instabilité du transistor ainsi que représenté à la figure 2, dans l'abaque de Smith.

En effet, l'impédance de la ligne microstrip, chargée par une impédance $Z_0$ (par exemple de 50 $\Omega$) et couplée magnétiquement à un résonateur a pour expression mathématique :

$$Z_2 \ (f \neq f_0) = Z_0 = 50 \ \Omega \text{ et } Z_2 \ (f = f_0) = e^{j\varphi} \ . \ 50 \ \Omega$$

où $f_0$ est la fréquence de résonance du résonateur, et $\varphi$ la phase de $Z_2$.

Le lieu géométrique des points représentatifs de cette impédance $Z_2(f)$ dans l'abaque de Smith est donc le point 0, centre de l'abaque, et la boucle quasi-circulaire tracée en pointillés et décrite dans le sens des aiguilles d'une montre.

Le disque hachuré représente la zone d'instabilité du transistor à une fréquence donnée ; ladite zone étant potentiellement instable, puisqu'elle ne contient pas le centre de l'abaque, alors que le module de $S_{22}$ (coefficient de réflexion en sortie) est inférieur à l'unité ( $|S_{22}| < 1$).

Selon une réalisation préférentielle du dispositif oscillateur-mélangeur, on réalise par un choix convenable des impédances, l'adaptation à l'entrée sur la première électrode de grille $(G_1)$ pour la fréquence du signal d'entrée (par exemple 12 GHz), de telle manière que le gain de conversion soit maximal, et l'adaptation à la sortie sur l'électrode de drain (D) pour la fréquence intermédiaire (par exemple 1 GHz).

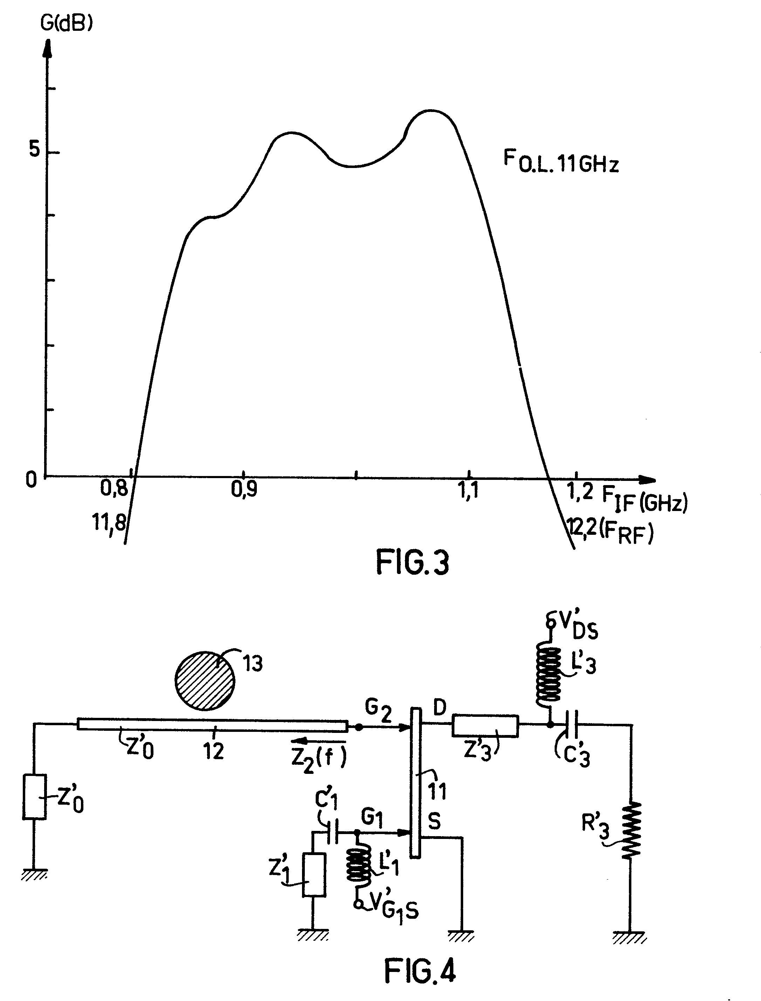

Pour un tel circuit adapté, le gain de conversion représenté à la figure 3 peut atteindre 5dB environ, à une fréquence intermédiaire comprise entre 0,9 et 1,1 GHz, pour un signal d'entrée de 11,9 à 12,1 GHz.

La figure 4 représente une variante de réalisation dans laquelle le dispositif constitue un simple oscillateur stabilisé par un résonateur diélectrique.

Selon cette variante, l'oscillateur comprend un transistor à effet de champ, à double grille du type Schottky, référencé 11 dans cette figure 4, et dont l'électrode de source est reliée à la masse, la première électrode de grille est soumise à une tension de polarisation $V'_{G_1S}$ à travers une inductance $L'_1$, alors qu'une branche en parallèle relie ladite première électrode de grille à la masse au travers d'un condensateur $C'_1$ et d'une impédance $Z'_1$, la deuxième électrode de grille est connectée à une première extrémité d'une ligne 12, de type microruban, d'impédance caractéristique $Z'_0$ (typiquement 50 $\Omega$), couplée magnétiquement avec un résonateur diélectrique 13, l'autre extrémité de ladite ligne 12 étant chargée par une impédance de même

valeur $Z'_0$, et enfin, l'électrode de drain sur laquelle est recueilli le signal d'oscillation est reliée à la masse au travers d'une impédance $Z'_3$, d'un condensateur $C'_3$ et d'une résistance de charge $R'_3$, typiquement 50 $\Omega$ et est soumise à une tension de polarisation $V'_{DS}$. à travers une inductance $L'_3$ connectée entre ladite impédance $Z'_3$ et ledit condensateur $C'_3$.

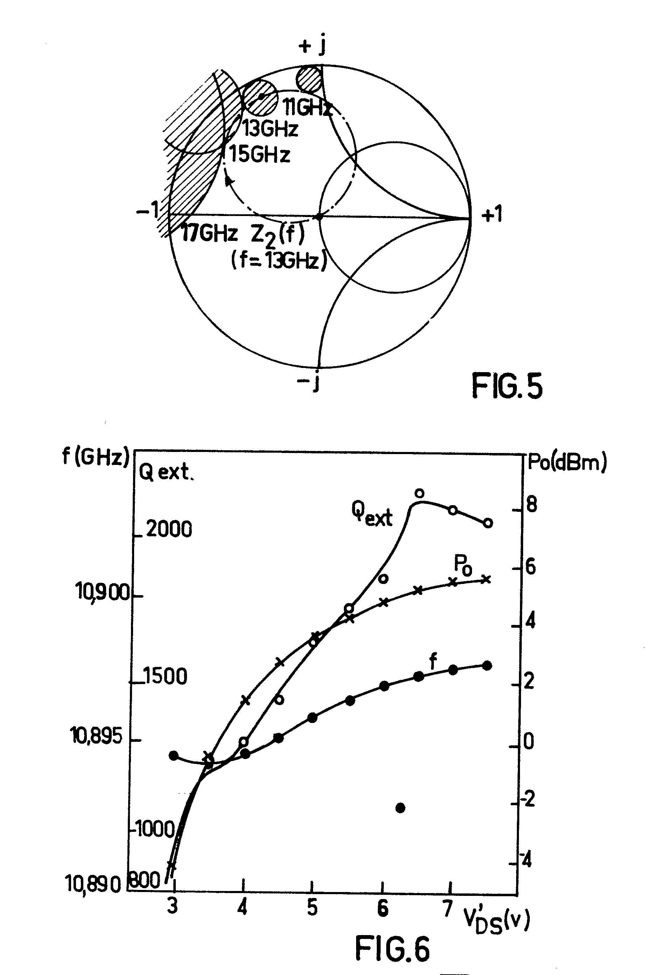

La figure 5 représente, dans l'abaque de Smith, les diverses zones d'instabilité par des disques hachurés, chaque disque correspondant à une fréquence donnée, ainsi par exemple pour 11 GHz, 13 GHz, 15 GHz et 17 GHz.

Il est à remarquer alors que les centres de ces disques se déplacent en fonction de la fréquence, de telle manière que la phase au centre du disque augmente avec la fréquence, alors que la phase $\varphi$ de $Z_2(f)$ décroît avec la fréquence, ce qui rend le système plus sélectif et donne à l'oscillateur un facteur de qualité Q encore plus élevé.

Selon une réalisation préférentielle de l'oscillateur, les impédances à la première électrode de grille ($G_1$) et à l'électrode de drain (D) sont choisies respectivement pour optimiser les conditions d'oscillation et rendre maximale la puissance d'oscillation délivrée par le dispositif.

De cette manière, il a été possible de réaliser des oscillateurs avec des transistors à effet de champ à double grille, stabilisés par un résonateur diélectrique, dans les bandes de fréquence X et $K_u$, qui s'étalent entre 8 et 18 GHz. La puissance délivrée sur la résistance de charge peut varier entre 4 mW (17,8 GHz) et 18 mW (16,3 GHz). Le facteur de qualité et la puissance de ce dispositif oscillateur ont été mesurés en fonction de la tension de polarisation de l'électrode de drain $V'_{DS}$, et représentés à la figure 6.

Il est bien évident pour l'homme de l'art que de nombreuses variantes peuvent être imaginées, sans pour cela faire oeuvre d'esprit, et donc sans sortir du cadre de la présente invention tel que délimité par les revendications ci-après annexées.

REVENDICATIONS :

1.         Dispositif oscillateur-mélangeur, du type comportant un transistor à effet de champ à double grille du type Schottky, destiné à fournir un signal de sortie à une fréquence dite intermédiaire, obtenu par mélange soustractif d'un signal d'entrée à haute fréquence et d'un signal créé dans le dispositif, le signal d'entrée étant appliqué sur la première électrode de grille ($G_1$), le signal créé étant contrôlé par la deuxième électrode de grille ($G_2$), et le signal de sortie étant récupéré sur l'électrode de drain (D), alors que l'électrode de source (S) est directement reliée à la masse, caractérisé en ce qu'une ligne du type microruban, d'une impédance caractéristique $Z_0$, couplée magnétiquement avec un résonateur diélectrique et chargée par une impédance ($Z_0$) est connectée à ladite deuxième électrode de grille ($G_2$).

2.         Dispositif oscillateur-mélangeur, selon la revendication 1, caractérisé en ce que l'impédance $Z_0$ a pour valeur 50 $\Omega$.

3.         Dispositif oscillateur-mélangeur, selon la revendication 1 ou 2, caractérisé en ce qu'une ligne ouverte quart d'onde du type microruban est branchée en parallèle sur l'électrode de drain, de manière à ne conserver en sortie que la fréquence intermédiaire et à éliminer les autres fréquences indésirables.

4.         Dispositif oscillateur-mélangeur, selon l'une des revendications 1 à 3, caractérisé en ce que les entrée et sortie sont adaptées aux fréquences respectives d'utilisation, de manière à ce que le gain de conversion de puissance soit maximal.

5.         Dispositif oscillateur, du type comportant un transistor à effet de champ à double grille du type Schottky, destiné à fournir sur l'électrode de drain (D) un signal de fréquence donné, l'électrode de source (S) étant directement reliée à la masse, caractérisé en ce qu'une ligne du type microruban, d'une impédance caractéristique $Z'_0$ couplée magnétiquement avec un résonateur diélectrique, dont la fréquence de résonance est celle désirée pour le signal, et chargée par une impédance ($Z'_0$), est connectée à la deuxième électrode de grille ($G_2$) en ce que la première électrode de grille, soumise à une tension de polarisation, est chargée par un circuit série comprenant au moins une impédance ($Z'_1$) et un condensateur ($C'_1$), et en ce que l'électrode de drain (D), soumise à une autre tension de polarisation, est chargée par un circuit série comprenant au moins une impédance de charge ($R'_3$) et un condensateur ($C'_3$).

6.      Dispositif oscillateur, selon la revendication 5, caractérisé en ce que l'impédance $Z'_0$ a pour valeur 50 $\Omega$.

7.      Dispositif oscillateur, selon la revendication 5 ou 6, caractérisé en ce que les impédances sur la première grille ($G_1$) et sur l'électrode de drain (D) sont choisies de manière à rendre maximale la puissance d'oscillation délivrée.

0057480

FIG.1

FIG.2

1-Ⅲ- PHF 81-502

0057480

FIG.3

FIG.4

FIG.5

FIG.6

**0057480**

Numéro de la demande

**Office européen des brevets**

**RAPPORT DE RECHERCHE EUROPEENNE**

EP 82 20 0069

| Catégorie | Citation du document avec indication, en cas de besoin, des parties pertinentes | Revendication concernée |
|---|---|---|
| Y | ELECTRONICS LETTERS, vol. 15, no. 17, 16 août 1979, pages 524-526 Londres, G.B. R. STAHLMANN et al.: "Dual-gate M.E.S.F.E.T. selfoscillating X-band mixers"<br><br>* En entier * | 1-7 |
| D,Y | 9th EUROPEAN MICROWAVE CONFERENCE Brighton, 17-20 septembre 1979, Microwave Exhibitions and Publishers Ltd., pages 321-325 Sevenoaks, G.B. C. TSIRONIS et al.: "A self-oscillating dual gate M.E.S.F.E.T. X-band mixer with 12 DB conversion gain"<br><br>* Page 321, ligne 27 - page 323, ligne 23; figure 3 * | 1-7 |
| Y | ELECTRONICS LETTERS, vol. 17, no. 1, 8 janvier 1981, pages 44-45 Londres, G.B. A. PODCAMENI et al.: "Stabilised fet oscillator with input dielectric resonator: Large signal design"<br><br>* En entier * | 1-7 |
| P,X | ELECTRONICS LETTTERS, vol. 17, no. 17, 20 août 1981, pages 617-618 Londres, G.B. C. TSIRONIS: "12GHz receiver with self-oscillating dual-gate mes-fet mixer"<br><br>* En entier * | 1-7 |

## DOCUMENTS CONSIDERES COMME PERTINENTS

**CLASSEMENT DE LA DEMANDE (Int. Cl. ³)**

H 03 D 9/06
H 03 B 5/18

**DOMAINES TECHNIQUES RECHERCHES (Int. Cl. ³)**

H 03 D
H 03 B

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 03-05-1982 | DHONDT |

OEB Form 1503.1 06.78